# EUROPÄISCHE PATENTSCHRIFT

(11) **EP 2 548 990 B1**
(45) Veröffentlichungstag und Bekanntmachung des Hinweises auf die Patenterteilung: **07.01.2015**
(21) Anmeldenummer: 11174663.2
(22) Anmeldetag: 20.07.2011
(51) Int. Cl.: C23C 14/02, C23C 14/06, F01D 5/28

(54) **Verfahren zur Herstellung von strömungsbelasteten Bauteilen sowie entsprechend hergestellte Bauteile**
Method for producing components liable to be exposed to fluid flows and products thus produced
Procédé de fabrication de composants susceptibles d'être exposés a des débits de gaz et composants ainsi fabriqués

(43) Veröffentlichungstag der Anmeldung: 23.01.2013
(73) Patentinhaber: MTU Aero Engines AG, 80995 München (DE)
(72) Erfinder: Uihlein, Thomas Dr., 85221 Dachau (DE); Heutling, Falko Dr., 81377 München (DE); Eichmann, Wolfgang, 82178 Puchheim (DE); Selmeier, Rudolf, 85777 Fahrenzhausen (DE)

(56) Entgegenhaltungen:
- EP-A1- 1 927 670
- WO-A1-2011/085376
- DE-T2-602004 006 349
- Coordinator: W G Woods: "Metals Handbook, ninth edition", 1982, American Society for Metals, Ohio, USA vol. 5, pages 303-309,

## Beschreibung

### HINTERGRUND DER ERFINDUNG

### GEBIET DER ERFINDUNG

Die vorliegende Erfindung betrifft ein Verfahren zur Herstellung von strömungsbelasteten Bauteilen sowie entsprechende Bauteile, insbesondere Bauteile von Gasturbinen oder Flugtriebwerken, wobei bei dem Verfahren ein Bauteil bereitgestellt wird und das Bauteil mit einer Schutzschicht versehen wird, die durch physikalische Dampfphasenabscheidung aufgebracht wird und wobei die Schutzschicht als Mehrlagenschicht ausgebildet ist, bei der mindestens zwei sich wiederholende Schichtabfolgen mit Teilschichten unterschiedlicher Zusammensetzungen und/oder Eigenschaften vorgesehen sind.

### STAND DER TECHNIK

Gasturbinen, wie z. B. Flugtriebwerke oder stationäre Gasturbinen, bestehen aus mehreren Baugruppen, nämlich einem Lüfter bzw. Fan, vorzugsweise mehreren Verdichtern, einer Brennkammer sowie vorzugsweise mehreren Turbinen. Zur Verbesserung des Wirkungsgrads und Arbeitsbereichs solcher Gasturbinen ist es erforderlich, das Umströmungsverhalten der Gasturbinenschaufeln, also der Laufschaufeln und Leitschaufeln, zu optimieren. Hierzu ist es beispielsweise aus der US 6,666,646 B1 bekannt, ein Gasturbinenbauteil zur Verminderung des Luftwiderstands mit sogenannten Riblet-Strukturen auszustatten. In der US 5,337,568 A wird wiederum vorgeschlagen, ein Schaufelblatt mit Mikrorillen zu versehen, um so eine Kühlwirkung zu erzielen. Die WO 03/104615 A1 schlägt zur Verminderung des Strömungswiderstands eines Werkstücks eine Haifischhaut vor. In der EP 1 371 813 A wird ebenfalls eine Strukturierung einer Laufschaufel eines Verdichters einer Gasturbine beschrieben.

Neben diesen Strukturierungen ist es jedoch auch wünschenswert, besonders glatte, sogenannte Superfinish-Oberflächen an strömungsbelasteten Bauteilen, wie beispielsweise Bauteilen von Gasturbinen, vorzusehen, um eine Reduzierung von aerodynamischen Verlusten zu bewirken. Beispielsweise ist in der WO 2009/049597 A2 eine Verschleißschutzbeschichtung für Gasturbinenbauteile beschrieben, bei welcher zur Erzielung einer glatten Oberfläche eine Glättungsschicht an der Oberfläche der Beschichtung aufgebracht ist.

Die EP 1927670 A1 beschreibt ebenfalls eine Verschleißschutzbeschichtung; bei der jedoch eine harte Grundschicht als Basis für das Mehrlagenschichtsystem der Verschleißschutzschicht aufgebracht wird. Die DE 60 2004 006 349 T2 beschreibt eine Verschleißschutzschicht, bei der eine Vielzahl von Nanoschichten vorgesehen sind.

Problematisch bei den oben beschriebenen Maßnahmen zur Gestaltung der Oberflächen von strömungsbelasteten Bauteilen ist jedoch die Tatsache, dass beim Betriebseinsatz durch Erosion die entsprechende Oberflächentopographie nach wenigen hundert oder tausend Stunden Betriebsdauer durch entsprechenden Erosionsabtrag wieder zerstört sein kann, so dass die Effizienz der entsprechenden Bauteile stark beeinträchtigt wird.

### OFFENBARUNG DER ERFINDUNG

### AUFGABE DER ERFINDUNG

Es ist deshalb Aufgabe der vorliegenden Erfindung, ein Verfahren zur Herstellung eines strömungsbelasteten Bauteils, wie beispielsweise ein Verfahren zur Herstellung von Bauteilen von Gasturbinen oder Flugtriebwerken, insbesondere Leit- und Laufschaufeln sowie entsprechende Bauteile bereitzustellen, bei denen in einfacher Weise eine gewünschte Oberflächentopographie erzielbar ist, die eine hohe Nutzungsdauer ermöglicht.

### TECHNISCHE LÖSUNG

Diese Aufgabe wird gelöst durch ein Verfahren zur Herstellung eines entsprechenden Bauteils mit dem Merkmal des Anspruchs 1 sowie durch ein entsprechendes Bauteil mit den Merkmalen des Anspruchs 7. Vorteilhafte Ausgestaltungen sind Gegenstand der abhängigen Ansprüche.

Die Erfindung geht aus von der Erkenntnis, dass eine entsprechende Oberflächentopographie eines Bauteils, sei es eine besonders glatte Oberfläche, beispielsweise eine hochglatte Superfinish-Oberfläche, oder eine strukturierte Oberfläche, beispielsweise eine Oberfläche mit Riblet-Strukturen oder Haifischstrukturen, unter Beibehaltung der Oberflächentopographie mit einer Schutzschicht versehen werden kann. Dies ist mittels der Aufbringung einer Mehrlagenschutzschicht aus einer Vielzahl von dünnen Teilschichten mittels physikalischer Dampf- oder Gasphasenabscheidung (Physical vapor deposition PVD) möglich. Bei der physikalischen Dampfphasenabscheidung handelt es sich um thermisches Verdampfen, Elektronenstrahlverdampfen, Laserstrahlverdampfen, Lichtbogenverdampfen, Molekularstrahlepitaxie, Sputtern, Ionenplattieren etc.

Durch die physikalische Gasphasenabscheidung und die Abscheidung mehrerer dünner Teilschichten bleibt die Oberflächentopographie auch nach Abscheiden der entsprechenden Schutzschicht erhalten, so dass besonders geglättete Bereiche oder Bereiche mit Strukturierungen entsprechend an der Oberfläche der Schutzschicht wieder abgebildet sind. Entsprechend lässt sich die Oberflächentopographie zunächst an dem Grundkörper des Bauteils erzeugen und anschließend können die entsprechenden Teilschichten des Schichtsystems aufgebracht werden. Dies hat weiterhin den Vorteil, dass auch die Grenzflächen zwischen den Teilschichten die entsprechende Topographie aufweisen, so dass bei einer Abtragung eines Teils der Schutzschicht die Oberflächentopographie erhalten bleiben kann. Darüber hinaus ist es mit dem erfindungsgemäßen Verfahren möglich, entsprechende Erosionsschutzschichten auf dem Grundkörper des Bauteils, der die glatten Oberflächenbereiche oder die strukturierten Oberflächenbereiche aufweist, aufzubringen, um so die entsprechenden Bereiche vor Erosion zu schützen. Beispiele für Mehrlagenerosionsschutzschichten oder Verschleißschutzschichten sind in der WO 2009/049 597 A2 beschrieben. Insbesondere können auf diese Weise glatte Superfinish-Oberflächen oder strukturierte Oberflächen an Bauteilen im Verdichterbereich von Triebwerken oder stationären Gasturbinen vorgesehen werden, die ihre aerodynamischen Eigenschaften über viele Betriebsstunden oder sogar lebenslang behalten, so dass beispielsweise ein hoher Verdichter-Wirkungsgrad mit niedrigem Treibstoffverbrauch und damit niedrigem CO₂-Ausstoß für lange Zeit erhalten werden kann. Bei Vorsehen von geglätteten Bereichen mit einer Superpolish- bzw. Superfinish-Oberfläche wird zudem das Aufwachsen der PVD-Schichten verbessert, indem weniger Schichtwachstumsfehler entstehen, so dass auch die Schichtqualitäten verbessert werden können.

Das Glätten und/oder Strukturieren der Oberfläche des Grundkörpers des Bauteils kann durch mechanische und/oder elektrochemische Oberflächenbehandlungen erfolgen, wie beispielsweise durch mechanisches Polieren. Darüber hinaus können die Oberflächen auch bestrahlt werden, was zu einer Einebnung von Unebenheiten und zu einem Verdichten des Oberflächenbereichs führen kann. Insgesamt können verschiedenste Verfahren zur Erzielung einer glatten Oberfläche an dem Grundkörper des Bauteils eingesetzt werden.

Darüber hinaus können auch die Oberflächen der Schutzschicht und/oder der Teilschichten nach entsprechender Teilabscheidung der Schicht in den gewünschten Bereichen geglättet und/oder strukturiert werden, so dass beispielsweise zusätzlich durch die vom Grundkörper des Bauteils vorgegebene Oberflächentopographie noch einmal verbessert werden kann.

Bei einer Glättung kann beispielsweise die Rauheit der zu beschichtenden Bauteiloberfläche, also des Grundkörpers des Bauteils, so eingestellt werden, dass der Mittenrauwert Rₐ kleiner als die Schichtdicke der anschließend aufzubringenden Schicht oder Teilschicht, insbesondere kleiner als 10 % der Schichtdicke der nachfolgend aufgebrachten Schicht oder Teilschicht ist.

Die Rauheit der zu beschichtenden Bauteiloberfläche und/oder der Schutzschichtoberfläche und/oder einer Teilschicht kann so eingestellt werden, dass die gemittelte Rautiefe R_{z} kleiner oder gleich 2 µm, höchst vorzugsweise kleiner oder gleich 1 µm ist.

Bei einem strukturierten Oberflächenbereich kann die maximale Strukturhöhe senkrecht zur zu beschichtenden Oberfläche so gewählt werden, dass sie kleiner ist als die nachfolgend aufgebrachte Schicht oder Teilschicht.

Bei der Schutzschicht kann es sich um eine Erosionsschutzschicht, eine Korrosionsschutzschicht, eine Oxidationsschutzschicht und/oder eine Hochtemperaturoxidationsschutzschicht handeln, wobei vorzugsweise der Einsatz von sogenannten Multilayer - Erosionsschutzschichten mit abwechselnden Schichten aus harten und weichen Materialien, wie beispielsweise eine Abfolge von keramischen und metallischen Schichten im Zusammenhang mit der vorliegenden Erfindung vorgesehen werden kann. Eine entsprechende Schicht kann Schichtdicken im Bereich von 5 µm bis 50 µm für die Gesamtschichtdicke aufweisen, wobei insbesondere Schichtdicken kleiner oder gleich 40 µm, vorzugsweise kleiner oder gleich 30 µm, höchst vorzugsweise kleiner oder gleich 20 µm vorgesehen sein können. Die Schichtdicke kann hierbei gleichmäßig über den gesamten Beschichtungsbereich eingestellt sein oder einen Schichtdickenverlauf aufweisen, beispielsweise in radialer Richtung vom Schaufelfuß zur Schaufelspitze mit zunehmender Schichtdicke. Die oben angegebenen Werte können sie hierbei sowohl auf den dicksten Schichtbereich als auch auf eine mittlere Schichtdicke beziehen.

Die Schutzschichten und insbesondere die Erosionsschutzschicht sowie die geglätteten oder strukturierten Bereiche können insbesondere an der Ein- und/oder Austrittskante der Leit- oder Laufschaufeln einer Gasturbine oder eines Flugtriebwerks, insbesondere eines Verdichters einer entsprechenden Gasturbine oder eines Flugtriebwerks sowie an den Schaufelspitzen vorgesehen sein. Der geglättete oder strukturierte Bereich sowie der Beschichtungsbereich können sich in einem Flächenbereich von bis zu zwei Dritteln, vorzugsweise bis zur Hälfte, insbesondere bis zu einem Drittel der Fläche der Druck- oder Saugseite angrenzend an die Ein- und/oder Austrittskante oder die Schaufelspitze erstrecken. Somit kann sich also die angegebene Ausdehnung des geglätteten oder strukturierten Bereichs in radialer und/oder axialer Richtung bezogen auf die Gasturbine bzw. das Triebwerk erstrecken.

Der oder die geglätteten Oberflächenbereiche und/oder der oder die Oberflächenbereiche mit Strukturierung können bei einem strömungsbelasteten Bauteil sowohl auf einer Druckseite als auch auf einer Saugseite sowie jeweils nur auf einer der Seiten vorgesehen sein. Bei einer Leit- oder Laufschaufel einer Gasturbine oder eines Flugtriebwerks kann insbesondere die Saugseite mit entsprechenden geglätteten oder strukturierten Bereichen versehen sein.

### KURZBESCHREIBUNG DER FIGUREN

Die beigefügten Figuren zeigen in rein schematischer Darstellung in
- Fig. 1: einen teilweisen Querschnitt für ein erfindungsgemäß hergestelltes Bauteil;
- Fig. 2: einen teilweisen Querschnitt durch eine weitere Ausführungsform eines erfindungsgemäß hergestellten Bauteils; und in
- Fig. 3: eine perspektivische Darstellung einer weiteren Ausführungsform eines erfindungsgemäßen Bauteils.

### AUSFÜHRUNGSBEISPIELE

Weitere Vorteile, Kennzeichen und Merkmale der vorliegenden Erfindung werden bei der nachfolgenden detaillierten Beschreibung von Ausführungsbeispielen anhand der beigefügten Zeichnungen deutlich. Die Erfindung ist jedoch nicht auf diese Ausführungsbeispiele beschränkt, sondern der Schutzbereich richtet sich einzig nach den beigefügten Ansprüchen.

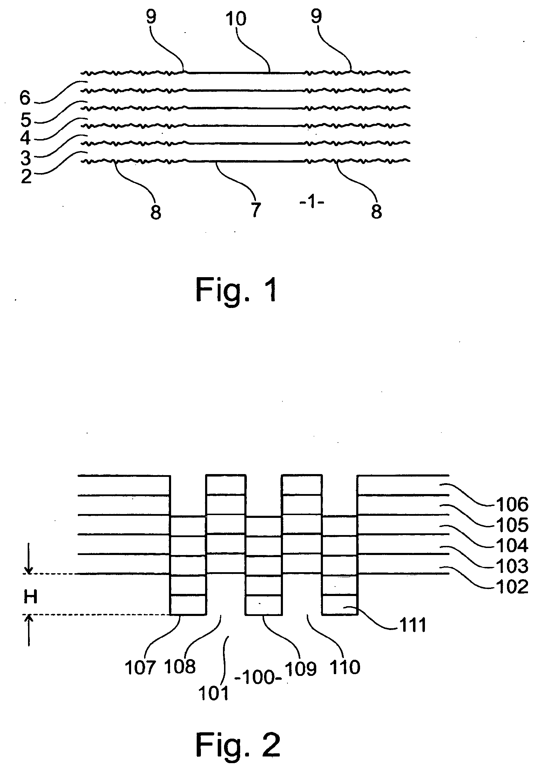

Die Fig. 1 zeigt einen teilweisen Querschnitt durch ein erfindungsgemäßes Bauteil mit einem Grundkörper 1 aus einem Grundwerkstoff, auf dem eine Schutzschicht mit einer Vielzahl von Teilschichten 2, 3, 4, 5, 6 aufgebracht ist. Die Teilschichten 2, 3, 4, 5, 6 sind so ausgebildet, dass sie teilweise unterschiedliche Zusammensetzungen und/oder Eigenschaften aufweisen. Beispielsweise kann für eine Erosionsschutzschicht der Schichtaufbau durch eine Haftvermittlerschicht umfassen, wobei die nachfolgenden Teilschichten 3, 4, 5, 6 durch wechselweise harte und duktile Schichten gebildet werden, die beispielsweise durch harte keramische Werkstoffe, wie Nitride, Karbide und dergleichen gebildet sein können sowie duktile Zwischenschichten aus metallischen Werkstoffen aufweisen können. So kann beispielsweise die Teilschicht 3 eine metallische Schicht sein, während die Teilschicht 4 eine Hartstoffschicht aus einem Nitrid, Karbid oder Borid vorzugsweise aus einem oder mehreren der Metalle der Teilschicht 3 ist. Die Teilschichten 5 und 6 sind eine Wiederholung der Schichten 3 und 4, wobei neben den gezeigten fünf Teilschichten einer derartigen Mehrlagenbeschichtung eine größere Anzahl von dünnen Teilschichten vorhanden sein kann, deren Schichtdicke sich im Bereich von wenigen Nanometern bis einigen Mikrometern bewegen kann.

Wie in der Fig. 1 dargestellt, weist die Grenzfläche zwischen Grundwerkstoff 1 und der ersten Teilschicht 2 zwei unterschiedliche Bereiche auf, nämlich einen geglätteten Bereich 7 sowie raue Bereiche 8. Der geglättete Bereich 7 weist eine niedrige Rauheit mit mittleren Rautiefen R_{z} im Bereich von 0,2 µm bis 2 µm, insbesondere 0,2 µm bis 1 µm auf. Durch die physikalische Dampfphasenabscheidung, mit der die Teilschichten 2 bis 6 der Schutzschicht auf den Grundwerkstoff 1 abgeschieden werden, wird die Oberflächenstruktur des Grundkörpers 1 in den jeweiligen Schichten abgebildet, so dass die Grenzflächen zwischen den einzelnen Teilschichten 2 bis 6 eine Topographie ähnlich der Oberflächentopographie des Grundkörpers 1 aufweisen. Entsprechend sind auch an der Oberfläche des Bauteils ein entsprechend geglätteter Bereich 10 sowie raue Bereiche 9 ausgebildet. Die Rauheit der Oberflächenbereiche auf der Schutzschicht kann im geglätteten Bereich 10 etwas größer sein als an der Grenzfläche zwischen Grundkörper 1 und Schutzschicht. Allerdings ist im geglätteten Bereich 10 die Rauheit weiterhin niedriger als in den rauen Bereichen 9. Sollte eine zusätzliche Glättung des geglätteten Bereichs 10 an der Oberfläche erforderlich sein, so kann ein entsprechender Glättungsschritt bei der Herstellung des Bauteils nach Aufbringen der Schutzschicht vorgenommen werden. Darüber hinaus können auch die Grenzflächen zwischen den einzelnen Teilschichten der Schutzschicht einem Glättungsverfahren unterzogen werden, sofern dies zur Aufrechterhaltung des geglätteten Bereichs im weiteren Beschichtungsverfahren erforderlich oder wünschenswert ist.

Somit wird bei der Herstellung des in Fig. 1 gezeigten Bauteils zunächst der Grundwerksotff des Grundkörpers 1 an der Oberfläche so behandelt, dass ein geglätteter Bereich 7 mit der gewunschten Rauheit durch entsprechende Glättungsverfahren, wie Polieren oder elektrochemisches Behandeln, erzeugt wird. Anschließend wird über physikalische Dampfphasenabscheidung die erste Teilschicht aufgebracht und anschließend die weiteren Teilschichten 3 bis 6. Falls erforderlich, kann zwischen dem Aufbringen der einzelnen Teilschichten ein weiterer Glättungsschritt vollzogen werden, mit dem der geglättete Bereich 7 an einer Grenzfläche zwischen zwei Teilschichten zusätzlich geglättet wird. Nach Abscheiden aller Teilschichten kann zudem die Oberfläche der Schutzschicht in dem geglätteten Bereich 10 ebenfalls durch weitere Glättungsbehandlung nachgeglättet werden.

Anstelle oder zusätzlich zu einem geglätteten Bereich an einer Oberfläche eines erfindungsgemäßen Bauteils kann ein erfindungsgemäßes Bauteil auch entsprechende mikrostrukturierte Bereiche, wie beispielsweise Riblet-Strukturen oder Haifischstrukturen, aufweisen. Dies ist schematisch in Fig. 2 in einer teilweisen Querschnittansicht dargestellt. In Fig. 2 ist wiederum ein Teil eines Grundkörpers 100 mit einem Grundwerkstoff gezeigt, in dessen Oberfläche durch entsprechende Oberflächenbearbeitung auf mechanische, chemische, elektrochemische oder vergleichbare Art Mikrostrukturen eingebracht sind. So weist bei dem rein schematisch dargestellten Ausführungsbeispiel der Fig. 2 der Grundkörper 100 drei Vertiefungen 107, 109 und 111 auf, die durch zwei Stege 108 und 110 voneinander getrennt sind. Die gezeigte Form der Oberflächentopographie des Grundkörpers 100 dient nur zur Veranschaulichung und hat nicht den Zweck, die tatsächlichen Strukturen, die beispielsweise bei Riblet-Strukturen oder Haifischstrukturen erzeugt werden, darzustellen. Auf den strukturierten Bereich 101 wird ebenso wie in den angrenzenden Oberflächenbereichen eine Mehrlagenschutzschicht mit Teilschicht 102, 103, 104, 105 und 106 durch physikalische Dampfphasenabscheidung aufgebracht. Die Schutzschicht kann beispielsweise wiederum eine Erosionsschutzschicht sein, wie sie bezüglich der Teilschichten 2 bis 6 in Bezug auf die Ausführungsform der Fig. 1 beschrieben worden ist. Eine entsprechende Wiederholung dieser Beschreibung ist deshalb entbehrlich.

Wie sich aus der Fig. 2 ergibt, wird durch die entsprechende Abscheidung der dünnen Teilschichten 102 bis 106 wiederum die in die Oberfläche des Grundkörpers 100 eingebrachte Strukturierung auf die Oberfläche der Schutzschicht abgebildet, so dass die entsprechende Strukturierung an der Oberfläche der Schutzschicht erhalten bleibt. Darüber hinaus ist darauf hinzuweisen, dass auch die Grenzflächen zwischen einzelnen Teilschichten 102 bis 106 ähnlich den Grenzflächen der Teilschichten 2 bis 6 des Ausführungsbeispiels der Fig. 1 eine vergleichbare Topographie wie die Oberfläche des Grundkörpers 1 bzw. 100 aufweisen, so dass bei einem Abtrag der Schutzschicht die Oberflächenstruktur gleichwohl erhalten bleiben kann. Werden beispielsweise die äußersten Schichten 5, 6 bzw. 105, 106 während der Nutzung des Bauteils durch Erosion abgetragen, so kann die Strukturierung oder Glättung der Oberfläche erhalten bleiben, da die darunterliegenden Teilschichten eine entsprechende Topographie aufweisen.

Um die Topographie über sämtliche Grenzflächen zwischen einzelnen Teilschichten bis zur Oberfläche der Schutzschicht zu erhalten, können die einzelnen Teilschichten sehr dünn, beispielsweise mit einer Dicke von weniger als 50 Nanometer, insbesondere weniger als 20 Nanometer, vorzugsweiser weniger als 10 Nanometer, aufgebracht werden und/oder die Anzahl der Teilschichten wird so klein wie möglich gehalten, beispielsweise im Bereich von weniger als 15 Teilschichten, vorzugsweise weniger als zehn Teilschichten, insbesondere weniger als fünf Teilschichten.

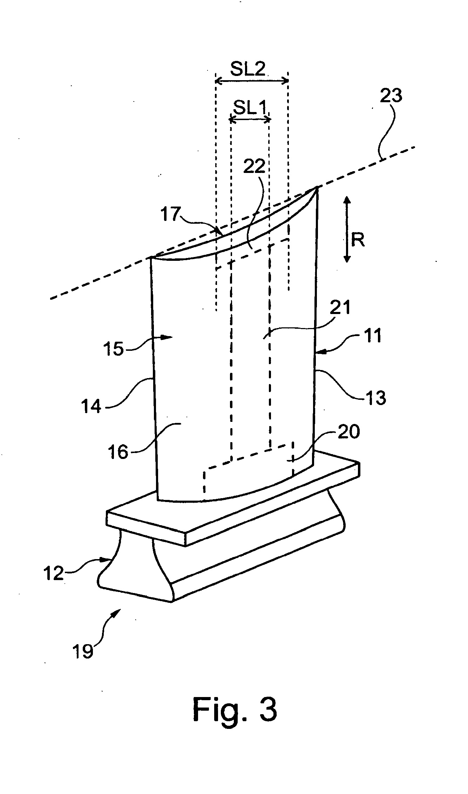

Fig. 3 zeigt ein Ausführungsbeispiel eines erfindungsgemäßen Bauteils in Form einer Gasturbinenschaufel 19, welche aus einem Schaufelblatt 11 und einem Schaufelfuß 12 aufgebaut ist. Das Schaufelblatt 11 wird von einer Strömungseintrittskante bzw. einer Vorderkante 13, einer Strömungsaustrittskante bzw. einer Hinterkante 14 und einer sich zwischen der Vorderkante 13 und der Hinterkante 14 erstreckenden Schaufelblattoberfläche 15 begrenzt. Die Schaufelblattoberfläche weist eine Saugseite 16 sowie eine Druckseite 17 auf. Zwischen der Vorderkante 13 und der Hinterkante 14 verläuft virtuell die Sehne 23, während der Doppelpfeil R die radiale Richtung der Gasturbinenschaufel 19 zeigt.

Auf der Saugseite 16 sind drei Bereiche 20, 21 und 22 dargestellt, welche eine entsprechende profilierte oder geglättete Struktur aufweisen können. Die Bereiche sind unterschiedlich ausgebildet, wobei beispielsweise sich der Bereich 22 mit einer Sehnenlänge SL2 am radial äußeren Rand des Schaufelblatts 19 befindet, während der Bereich 21 sich mit der Sehnenlänge SL1 von dem Bereich 20 bis zum Bereich 22 über nahezu die gesamte radiale Länge der Gasturbinenschaufel 19 erstreckt.

Die Bereiche 20, 21, 22 sind lediglich rein schematisch zur Verdeutlichung gezeigt und müssen weder in der Anordnung noch in der Form den Bereichen entsprechen, die tatsächlich für eine strömungstechnisch günstige Ausbildung einer Gasturbinenschaufel 19 erforderlich sind. Vielmehr können die entsprechenden Bereiche 20, 21, 22 individuell für jede Lauf- oder Leitschaufel einer Gasturbine oder eines Flugtriebwerks so bestimmt werden, wie die strömungstechnischen Anforderungen dies erforderlich machen.

Obwohl die vorliegende Erfindung anhand der Ausführungsbeispielse detailliert beschrieben worden ist, ist für einen Fachmann klar, dass die Erfindung nicht auf diese Ausführungsbeispiele beschränkt ist, sondern dass Abwandlungen in der Weise möglich sind, dass einzelne Merkmale weggelassen werden oder andersartige Kombinationen von Merkmalen verwirklicht werden, ohne dabei den Schutzbereich der beigefügten Ansprüche zu verlassen. Die Offenbarung schließt insbesondere alle möglichen Kombinationen der vorgestellten einzelnen Merkmale ein.

## Patentansprüche

1. Verfahren zur Herstellung von strömungsbelasteten Bauteilen (1, 19, 100), insbesondere Bauteilen von Gasturbinen oder Flugtriebwerken, bei welchem ein Bauteil bereit gestellt wird und das Bauteil mit einer Schutzschicht versehen wird, die durch physikalische Dampfphasenabscheidung aufgebracht wird, wobei die Schutzschicht als Mehrlagenschicht (2, 3, 4, 5, 6; 102, 103, 104, 105, 106) aufgebracht wird, bei der mindestens zwei sich wiederholende Schichtabfolgen mit Teilschichten unterschiedlicher Zusammensetzungen und/oder Eigenschaften abgeschieden werden,
**dadurch gekennzeichnet, dass**
mindestens teilweise die Oberfläche (7, 101) des Bauteils vor dem Aufbringen der Schutzschicht auf eine mittlere Rautiefe R_{Z} kleiner oder gleich 3µm geglättet oder mit Oberflächenstrukturen versehen wird.

2. Verfahren nach Anspruch 1,
**dadurch gekennzeichnet, dass**
die Schutzschicht und/oder Teilschichten ebenfalls zumindest teilweise geglättet und/oder strukturiert werden.

3. Verfahren nach Anspruch 1 oder 2,
**dadurch gekennzeichnet, dass**
das Glätten und/oder Strukturieren durch mechanischen und/oder elektrochemischen Oberflächenabtrag und/oder Verdichten erfolgt.

4. Verfahren nach einem der vorhergehenden Ansprüche,
**dadurch gekennzeichnet, dass**
die Rauheit zumindest eines Teils (7) der zu beschichtenden Bauteiloberfläche so eingestellt wird, dass der Mittenrauwert Rₐ kleiner als die Schichtdicke, insbesondere kleiner als 10% der Schichtdicke der nachfolgend aufgebrachten Schicht oder Teilschicht ist.

5. Verfahren nach einem der vorhergehenden Ansprüche,
**dadurch gekennzeichnet, dass**
die Rauheit zumindest eines Teils (7) der zu beschichtenden Bauteiloberfläche und/oder der Schutzschichtoberfläche und/oder einer Teilschicht so eingestellt wird, dass die gemittelte Rautiefe R_{z} kleiner oder gleich 2 µm oder kleiner oder gleich 1 µm ist.

6. Verfahren nach einem der vorhergehenden Ansprüche,
**dadurch gekennzeichnet, dass**
die Strukturierung so erfolgt, dass die maximale Strukturhöhe in Richtung senkrecht zur zu beschichtenden Oberfläche kleiner als die nachfolgend aufgebrachte Schicht oder Teilschicht ist.

7. Strömungsbelastetes Bauteil, insbesondere Bauteil einer Gasturbine oder eines Flugtriebwerks mit einem Grundkörper (1, 100) aus einem Grundwerkstoff und einer zumindest teilweise auf dem Grundwerkstoff angeordneten Schutzschicht, wobei die Schutzschicht als Mehrlagenschicht (2, 3, 4, 5, 6; 102, 103, 104, 105, 106) ausgebildet ist, bei der mindestens zwei sich wiederholende Schichtabfolgen mit Teilschichten unterschiedlicher Zusammensetzung und/oder Eigenschaften vorliegen,
**dadurch gekennzeichnet, dass**
zumindest ein Teil einer Grenzfläche zwischen Grundwerkstoff und Schutzschicht eine Strukturierung aufweist und/oder einen geglätteten Bereich mit einer Rauheit mit einer mittleren Rautiefe R_{Z} kleiner oder gleich 3 µm aufweist.

8. Bauteil nach Anspruch 7,
**dadurch gekennzeichnet, dass**
die mittlere Rautiefe R_{Z} kleiner oder gleich 2 µm oder kleiner oder gleich 1 µm ist.

9. Bauteil nach einem der Ansprüche 7 bis 8,
**dadurch gekennzeichnet, dass**
die Schutzschicht eine Erosionsschutzschicht, eine Korrosionsschutzschicht, eine Oxidationsschutzschicht und/oder eine Hochtemperaturoxidationsschutzschicht ist.

10. Bauteil nach einem der Ansprüche 7 bis 9,
**dadurch gekennzeichnet, dass**
das Bauteil bezüglich einer Fluidströmung im Betrieb eine Druckseite (17) und eine Saugseite (16) aufweist, wobei der geglättete Bereich und/oder die Oberflächenstrukturierung sowohl auf der Druckseite als auch auf der Saugseite vorgesehen sind oder nur an der Saugseite oder nur an der Druckseite angeordnet sind.

11. Bauteil nach einem der Ansprüche 7 bis 10,
**dadurch gekennzeichnet, dass**
das Bauteil eine Laufschaufel oder eine Leitschaufel einer Gasturbine oder eines Flugtriebwerks ist.

12. Bauteil nach Anspruch 11,
**dadurch gekennzeichnet, dass**
der geglättete oder strukturierte Bereich (20, 21, 22) sich im Bereich von 0 % bis 60 %, insbesondere 5 % bis 60 %, vorzugsweise 5 % bis 30 % einer Sehnenlänge über die radiale Richtung einer Lauf- oder Leitschaufel erstreckt, wobei die Sehnenbereiche in einer Richtung quer zur radialen Richtung im Hinblick auf Lage und Ausdehnung variieren können.

13. Bauteil nach Anspruch 11,
**dadurch gekennzeichnet, dass**
der geglättete oder strukturierte Bereich (20, 21, 22) an der Ein- und/oder Austrittskante, an der Schaufelspitze, einem Flächenbereich von bis zu zwei Dritteln, vorzugsweise bis zur Hälfte, insbesondere bis zu einem Drittel der Druck- oder Saugseite angrenzend an die Ein- oder Austrittskante oder die Schaufelspitze angeordnet ist.

14. Bauteil nach einem der Ansprüche,
**dadurch gekennzeichnet, dass**
die Schutzschicht eine Gesamtdicke im dicksten Bereich von kleiner oder gleich 40 µm, vorzugsweise kleiner gleich 30 µm und/oder eine mittlere Dicke von kleiner oder gleich 30 µm, insbesondere kleiner oder gleich 20 µm aufweist.

15. Bauteil nach einem der Ansprüche 7 bis 14,
**dadurch gekennzeichnet, dass**
die Topographie der Grenzschicht zwischen der Schutzschicht und dem Grundkörper in den Grenzflächen zwischen den Teilschichten der Schutzschicht und an der Oberfläche der Schutzschicht erhalten bleibt, wobei insbesondere die Anzahl und/oder Dicke der Teilschichten klein gehalten wird.

16. Bauteil nach einem der Ansprüche 7 bis 15,
**dadurch gekennzeichnet, dass**
es mit dem Verfahren nach einem der Ansprüche 1 bis 6 hergestellt ist.

## Claims

1. Method for producing flow-loaded components (1, 19, 100), in particular components of gas turbines or aircraft engines, in which a component is made available and the component is provided with a protective layer which is applied by physical vapour deposition, the protective layer being applied as a multilayer layer (2, 3, 4, 5, 6; 102, 103, 104, 105, 106), in which at least two repeating layer sequences are deposited with partial layers of different compositions and/or properties,
**characterised in that**
at least partially the surface (7, 101) of the component, before the application of the protective layer, is smoothed to an average surface roughness R_{Z} of less than or equal to 3 µm, or is provided with surface structures.

2. Method according to Claim 1,
**characterised in that**
the protective layer and/or partial layers are likewise at least partially smoothed and/or structured.

3. Method according to Claim 1 or 2,
**characterised in that**
the smoothing and/or structuring is carried out by mechanical and/or electrochemical surface removal and/or compressing.

4. Method according to one of the preceding claims,
**characterised in that**
the roughness of at least one part (7) of the component surface to be coated is set such that the average roughness Rₐ is less than the layer thickness, in particular less than 10% of the layer thickness of the subsequently applied layer or partial layer.

5. Method according to one of the preceding claims,
**characterised in that**
the roughness of at least one part (7) of the component surface to be coated and/or of the protective layer surface and/or of a partial layer is set such that the average surface roughness R_{z} is less than or equal to 2 µm or less than or equal to 1 µm.

6. Method according to one of the preceding claims,
**characterised in that**
the structuring is carried out such that the maximum structure height in the direction perpendicular to the surface to be coated is less than the subsequently applied layer or partial layer.

7. Flow-loaded component, in particular component of a gas turbine or an aircraft engine having a base body (1, 100) made of a base material and a protective layer at least partially arranged on the base material, the protective layer being formed as a multilayer layer (2, 3, 4, 5, 6; 102, 103, 104, 105, 106), in which at least two repeating layer sequences with partial layers of different composition and/or properties are present,
**characterised in that**
at least one part of an interface between the base material and the protective layer has a structuring and/or a smoothed region having a roughness with an average surface roughness R_{Z} of less than or equal to 3 µm.

8. Component according to Claim 7,
**characterised in that**
the average surface roughness R_{Z} is less than or equal to 2 µm or less than or equal to 1 µm.

9. Component according to one of Claims 7 to 8,
**characterised in that**
the protective layer is an erosion protective layer, a corrosion protective layer, an oxidation protective layer and/or a high-temperature oxidation protective layer.

10. Component according to one of Claims 7 to 9,
**characterised in that**
the component has, with respect to a fluid flow in operation, a pressure sidle (17) and a suction side (16), the smoothed region and/or the surface structuring being provided both on the pressure side and on the suction side or arranged only on the suction side or only on the pressure side.

11. Component according to one of Claims 7 to 10,
**characterised in that**
the component is a moving blade or a guide blade of a gas turbine or an aircraft engine.

12. Component according to Claim 11,
**characterised in that**
the smoothed or structured region (20, 21, 22) extends in the range from 0% to 60%, in particular 5% to 60%, preferably 5% to 30% of a chord length over the radial direction of a moving blade or guide blade, it being possible for the chord regions to vary in a direction transversely to the radial direction with regard to position and extent.

13. Component according to Claim 11,
**characterised in that**
the smoothed or structured region (20, 21, 22) is arranged at the entering and/or leaving edge, at the blade tip, a surface region of up to two thirds, preferably up to half, in particular up to one third of the pressure or suction side adjoining the entering or leaving edge or the blade tip.

14. Component according to one of the claims,
**characterised in that**
the protective layer has a total thickness in the thickest region of less than or equal to 40 µm, preferably less than or equal to 30 µm and/or an average thickness of less than or equal to 30 µm, in particular less than or equal to 20 µm.

15. Component according to one of Claims 7 to 14,
**characterised in that**
the topography of the boundary layer between the protective layer and the base body in the interfaces between the partial layers of the protective layer and at the surface of the protective layer is preserved, with in particular the number and/or thickness of the partial layers being kept small.

16. Component according to one of Claims 7 to 15,
**characterised in that**
it is produced using the method according to one of Claims 1 to 6.

## Revendications

1. Procédé de fabrication de composants (1, 19, 100) exposés à des flux, en particulier de composants de turbines à gaz ou de moteurs d'avion, où un composant est préparé et ledit composant est pourvu d'une couche de protection, laquelle est appliquée par dépôt physique en phase vapeur, ladite couche de protection étant appliquée sous forme de film multicouches (2, 3, 4, 5, 6 ; 102, 103, 104, 105, 106), où au moins deux séquences de couches répétées sont séparées par des couches partielles de compositions et/ou de propriétés différentes,
**caractérisé en ce que**
la surface (7, 101) du composant est au moins partiellement lissée avec une profondeur de rugosité moyenne R_{Z} inférieure ou égale à 3 µm, ou pourvue de structures de surface avant l'application de la couche de protection.

2. Procédé selon la revendication 1,
**caractérisé en ce que**
la couche de protection et/ou les couches partielles sont également au moins partiellement lissées et/ou structurées.

3. Procédé selon la revendication 1 ou 2,
**caractérisé en ce que**
le lissage et/ou la structuration sont effectués par abrasion mécanique et/ou électrochimique de surface et/ou par compactage.

4. Procédé selon l'une des revendications précédentes,
**caractérisé en ce que**
la rugosité d'au moins une partie (7) de la surface de composant à revêtir est ajustée de telle manière que la valeur de rugosité moyenne Rₐ soit inférieure à l'épaisseur de couche, en particulier inférieure à 10 % de l'épaisseur de la couche ou de la couche partielle suivante appliquée.

5. Procédé selon l'une des revendications précédentes,
**caractérisé en ce que**
la rugosité d'au moins une partie (7) de la surface de composant à revêtir et/ou de la surface de couche de protection et/ou d'une couche partielle est ajustée de telle manière que à rugosité moyenne R_{Z} soit inférieure ou égale à 2 µm, ou inférieure ou égale à 1 µm.

6. Procédé selon l'une des revendications précédentes,
**caractérisé en ce que**
la structuration est effectuée de telle manière que la hauteur de structure maximale perpendiculairement à la surface à revêtir soit inférieure à la couche ou la couche partielle suivante appliquée.

7. Composant exposé à des flux, en particulier composant de turbine à gaz ou de moteur d'avion, avec un corps de base (1, 100) en matériau de base, et une couche de protection appliquée au moins partiellement sur le matériau de base, la couche de protection étant réalisée sous forme de film multicouches (2, 3, 4, 5, 6 ; 102, 103, 104, 105, 106) où au moins deux séquences de couches répétées sont séparées par des couches partielles de compositions et/ou de propriétés différentes,
**caractérisé en ce que**
au moins une partie d'une surface de délimitation entre le matériau de base et la couche de protection présente une structuration et/ou une zone lissée avec une rugosité ayant une profondeur de rugosité moyenne R_{Z} inférieure ou égale à 3 µm.

8. Composant selon la revendication 7,
**caractérisé en ce que**
la profondeur de rugosité moyenne R_{Z} est inférieure ou égale à 2 µm, ou inférieure ou égale à 1 µm.

9. Composant selon l'une des revendications 7 à 8,
**caractérisé en ce que**
la couche de protection est une couche de protection contre l'érosion, une couche de protection contre la corrosion, une couche de protection contre l'oxydation et/ou une couche de protection contre l'oxydation à haute température.

10. Composant selon l'une des revendications 7 à 9,
**caractérisé en ce que**
le composant présente en état de service un côté pression (17) et un côté aspiration (16) par rapport à un flux de fluide, la zone lissée et/ou la structuration de surface étant prévues côté pression ainsi que côté aspiration, ou n'étant disposées que côté aspiration ou que côté pression.

11. Composant selon l'une des revendications 7 à 10,
**caractérisé en ce que**
ledit composant est une aube mobile ou une aube directrice d'une turbine à gaz ou d'un moteur d'avion.

12. Composant selon la revendication 11,
**caractérisé en ce que**
la zone lissée ou structurée (20, 21, 22) s'étend entre 0 % et 60 %, en particulier entre 5 % et 60 %, préférentiellement entre 5 % et 30 % d'une longueur de corde dans la direction radiale d'une aube mobile ou directrice, les zones de corde pouvant varier quant à leur position et leur extension dans une direction perpendiculaire à la direction radiale.

13. Composant selon la revendication 11,
**caractérisé en ce que**
la zone lissée ou structurée (20, 21, 22) est disposée de manière adjacente au bord d'entrée et/ou au bord de sortie, au sommet de pale, sur une partie surfacique jusqu'aux deux tiers, préférentiellement jusqu'à la moitié, en particulier jusqu'à un tiers du côté pression ou du côté aspiration.

14. Composant selon l'une des revendications,
**caractérisé en ce que**
la couche de protection présente dans la zone la plus épaisse une épaisseur inférieure ou égale à 40 µm, préférentiellement inférieure ou égale à 30 µm et/ou une épaisseur moyenne inférieure ou égale à 30 µm, en particulier inférieure ou égale à 20 µm.

15. Composant selon l'une des revendications 7 à 14,
**caractérisé en ce que**
la topographie de la couche de délimitation entre la couche de protection et le corps de base est conservée dans les surfaces de délimitation entre les couches partielles de la couche de protection et sur la surface de la couche de protection, le nombre et/ou l'épaisseur des couches partielles restant notamment réduits.

16. Composant selon l'une des revendications 7 à 15,
**caractérisé en ce que**
il est fabriqué au moyen du procédé selon l'une des revendications 1 à 6.
